# EUROPÄISCHE PATENTANMELDUNG

(11) **EP 4 366 479 A1**
(43) Veröffentlichungstag der Anmeldung: **08.05.2024**
(21) Anmeldenummer: 23207540.8
(22) Anmeldetag: 02.11.2023
(51) Int. Cl.: H05K 5/02

(54) **DRUCKAUSGLEICHSELEMENT**

(30) Priorität: 04.11.2022 CH 13062022
(71) Anmelder: Agro AG, 5502 Hunzenschwil (CH)
(72) Erfinder: Rosamilia, Valerio, 5502 Hunzenschwil (CH); Wassmer, Thomas, 3102 Rupperswil (CH)
(74) Vertreter: Rentsch Partner AG

(57) **Zusammenfassung**

Die Erfindung betrifft ein Druckausgleichselement (1) zur Bereitstellung eines Druckausgleichs. Das Druckausgleichselement (1) umfasst ein röhrenförmiges Basiselement (2) mit einer vom röhrenförmigen Basiselement (2) ausgebildeten Durchgangsöffnung (3), eine Abdeckung (4), eine Membran (7) sowie ein Dichtelement (8), wobei die Abdeckung (4) die Membran (7) sowie das Dichtelement (8) jeweils in der Durchgangsöffnung angeordnet sind und wobei die Membran (7) und das Dichtelement (8) in axialer Richtung zumindest bereichsweise zwischen dem Basiselement (2) und der Abdeckung (4) von der Abdeckung (4) gehalten werden.

## Beschreibung

Die vorliegende Erfindung bezieht sich auf ein Druckausgleichselement zur Bereitstellung eines Druckausgleichs.

### HINTERGRUND DER ERFINDUNG

Druckausgleichselemente sorgen für einen zuverlässigen Druckausgleich in Gehäusen, die im Aussenbereich eingesetzt werden wie beispielsweise Gehäuse von Elektronikkomponenten, Fahrzeugkomponenten, Verpackungen, etc. Je nach Anwendungsgebiet gleichen Druckausgleichselemente den Innendruck in einem Gehäuse aus, um Leckagen zu verhindern und/oder regeln die Diffusion zum Transport ausgewählter Stoffe wie beispielsweise die Diffusion von Wasser zur Feuchtigkeitsregulierung und/oder bilden eine Barriere gegen Verunreinigungen. Deshalb ist bei vielen Anwendungen das Druckausgleichselement nicht nur gasdurchlässig um einen Druckausgleich zu ermöglichen, sondern auch flüssigkeitsundurchlässig. Des Weiteren haben Druckausgleichselemente i.d.R. eine hohe Widerstandsfähigkeit gegen eine Vielzahl von Stoffen, wie beispielsweise eine chemische Beständigkeit gegen unterschiedliche Chemikalien, und/oder eine hohe mechanische Stabilität, wie beispielsweise gegen Schlagbelastungen sowie oftmals eine hohe Witterungsbeständigkeit, ohne an Dichtkraft zu verlieren. Weiterhin besteht die zusätzliche Anforderung an eine kostengünstige Produktion dieser Bauteile.

Aus dem Stand der Technik sind Druckausgleichselemente bekannt. Beispielsweise bezieht sich die EP1740861 B1, welche am 26.11.2008 in Namen der Gore Enterprise Holdings Inc. veröffentlicht wurde, auf ein Druckausgleichselement aus Metall, bei welchem eine Metallhülse verwendet wird, um die Membran mit dem Basiselement des Druckausgleichselementes abzudichten. Die Metallhülse wird dabei mittels Presspassung, sowie je nach Ausführungsform zusätzlich mittels einem Formschluss am Basiselement des Druckausgleichselements befestigt.

In der EP3236722 B1, welche am 30.09.2020 im Namen der W. L. Gore & Associates GmbH veröffentlicht wurde, wird zur Abdichtung eine Klemmanordnung mit mindestens einem gespannten Federelement das vorzugsweise aus Metall besteht, wobei die Membran in einem Klemmbereich der Membran mit einer Druckkraft je Flächeneinheit gegen die Dichtungsfläche des Basiselements drückt, verwendet. So wird verhindert, dass Flüssigkeit zwischen Dichtungsfläche und der Membran hindurch verläuft.

Ein Nachteil solcher aus dem Stand der Technik bekannten Druckausgleichselementen besteht jedoch darin, dass diese aufwendig im konstruktiven Aufbau sind. Derartige Aufbauten sind zudem aufwendig in der Montage und teuer in der Herstellung.

### ZUSAMMENFASSUNG DER ERFINDUNG

Die Aufgabe der Erfindung ist es daher ein einfach aufgebautes und/oder einfach zu montierendes Druckausgleichselement bereitzustellen. Eine weitere Aufgabe der Erfindung ist es ein Druckausgleichselement mit verbesserten Dichtungseigenschaften bereitzustellen.

Die vorliegende Erfindung bezieht sich auf ein Druckausgleichselement zur Bereitstellung eines Druckausgleichs. Das Druckausgleichselement umfasst ein röhrenförmiges Basiselement und eine Abdeckung. Das röhrenförmige Basiselement erstreckt sich hierbei in eine axiale Richtung und bildet (respektive umgibt) eine Durchgangsöffnung aus. Die Abdeckung ist an einem vorderseitigen Ende des Basiselementes in der Durchgangsöffnung, insbesondere gänzlich in der Durchgangsöffnung, angeordnet. D.h. mit Vorteil ist die Abdeckung in der Durchgangsöffnung versenkt angeordnet. In der Durchgangsöffnung ist zudem eine Membran angeordnet. Weiterhin kann die Membran gasdurchlässig sein. Die Membran kann weiter derart in der Durchgangsöffnung positioniert sein, dass diese mit Vorteil den Durchtritt von Flüssigkeiten durch die Durchgangsöffnung behindert und/oder verhindert. D.h. die Membran kann flüssigkeitsundurchlässig sein. Unter flüssigkeitsundurchlässig wird in diesem Kontext verstanden, dass je nach Membranmaterial minimale Wassereintrittspunkte bei sehr hohen Drücken (typischer Wassereintrittsdruck >1000 mbar bei einer Prüffläche von 1 cm²) dennoch auftreten können. Weiterhin ist in der Durchgangsöffnung in axialer Richtung zwischen der Membran und der Abdeckung ein Dichtelement vorhanden. Die Membran und das Dichtelement sind ferner je in axialer Richtung zumindest bereichsweise zwischen dem Basiselement und der Abdeckung angeordnet und werden von der Abdeckung gehalten. Mit Vorzug ist das Dichtelement in axialer Richtung gänzlich zwischen dem Basiselement und der Abdeckung angeordnet. Diese Anordnung von Abdeckung und Dichtelement hat den Vorteil, dass ein direkter Kontakt durch einen Flüssigkeitsstrahl auf die Membran verhindert werden kann. Dadurch kann das Druckausgleichselement auch für ein Gehäuse verwendet werden, welches beispielsweise einer Hochdruckreinigung ausgesetzt ist.

Die Durchgangsöffnung weist mit Vorteil in die axiale Richtung verschiedene Abschnitte mit unterschiedlichen Durchmessern und/oder Konturen auf. Beispielsweise kann die Durchgangsöffnung an einem dem vorderseitigen Ende gegenüberliegenden rückseitigen Ende einen kleineren Durchmesser aufweisen als an dem vorderseitigen Ende. Weiterhin kann die Durchgangsöffnung einen Absatz, insbesondere einen umlaufenden Absatz, zur Anlage der Membran in die axiale Richtung aufweisen. Der Absatz kann hierbei derart ausgestaltet sein, dass die Membran von dem vorderseitigen Ende in das röhrenförmige Basiselement einbringbar ist. Der Absatz kann senkrecht oder abgewinkelt zur axialen Richtung orientiert sein. Weiterhin kann die Durchgangsöffnung einen Anschlag in axialer Richtung für die Abdeckung aufweisen. Dieser kann in axialer Richtung zwischen dem Absatz zur Anlage der Membran und dem vorderseitigen Ende angeordnet sein. Die Durchgangsöffnung kann zudem einen Halteabschnitt zum Halten der Abdeckung und/oder einen Dichtabschnitt zur Aufnahme des Dichtelementes und der Membran und/oder einen rückseitigen Abschnitt umfassen. Der rückseitige Abschnitt ist hierbei zumindest teilweise in axialer Richtung von einem Aussengewinde am Basiselement umgeben. Das Aussengewinde dient zur Befestigung des Druckausgleichselementes z.B. in einer Gehäusewand oder ähnlichen. Die Abdeckung kann formschlüssig und/oder kraftschlüssig in der Durchgangsöffnung, insbesondere in dem Halteabschnitt, gehalten sein. Zwischen dem Halteabschnitt und dem Dichtabschnitt ist der zuvor beschriebene Anschlag angeordnet. Zwischen dem Dichtabschnitt und dem rückseitigen Abschnitt ist der zuvor beschriebene Absatz zur Anlage der Membran angeordnet.

Die Abdeckung verschliesst die Durchgangsöffnung nicht vollständig, sondern lässt mindestens einen Belüftungskanal frei. Der mindestens eine Belüftungskanal kann hierbei zwischen der Abdeckung und dem Basiselement angeordnet sein und/oder sich zumindest bereichsweise durch die Abdeckung erstrecken, wie nachgehend im Detail beschrieben. Der mindestens eine Belüftungskanal kann also von einem Teil der Durchgangsöffnung ausgebildet sein, welche nicht von der Abdeckung verblockt wird. Mit Vorteil sind mehrere um den Umfang der Abdeckung herum angeordnete Belüftungskanäle vorhanden.

Zur Ausbildung eines Belüftungskanals kann eine Innenkontur der Durchgangsöffnung im Bereich des vorderseitigen Endes des Basiselementes (insbesondere im Halteabschnitt) derart von einer Aussenkontur der Abdeckung abweichen, dass mindestens ein Belüftungskanal dazwischen ausgebildet wird. Der mindestens eine Belüftungskanal kann sich hierbei zwischen der Abdeckung und dem Basiselement und/oder zumindest bereichsweise durch die Abdeckung erstrecken. Im Fall mindestens eines Belüftungskanals, welcher sich zwischen der Abdeckung und dem Basiselement erstreckt, kann dieser (bereichsweise) durch einen Spalt zwischen der Abdeckung und dem Basiselement verlaufen. Hierzu kann eine Innenkontur der Durchgangsöffnung in dem Halteabschnitt der Durchgangsöffnung von einer Aussenkontur der im dem Halteabschnitt aufgenommenen Abdeckung abweichen. Durch die Abweichung wird der mindestens eine Belüftungskanal zwischen der Abdeckung und dem Basiselement ausgebildet. Beispielsweise kann die Aussenkontur der Abdeckung mindestens ein erstes Segment und mindestens ein zweites Segment umfassen, wobei das erste Segment der Innenkontur der Durchgangsöffnung in dem Halteabschnitt folgt und das zweite Segment von dieser Innenkontur radial nach innen abweicht. Mit Vorteil sind jedoch um den Umfang verteilt und einander abwechselnde erste und zweite Segmente vorhanden. Hierbei bietet es sich an, wenn die Innenkontur der Durchgangsöffnung in dem Halteabschnitt rund ist und die Aussenkontur der Abdeckung eine andersartige Ausgestaltung aufweist. Z. B. kann die Aussenkontur der Abdeckung ein Polygon mit abgerundeten Ecken sein, wobei die abgerundeten Ecken je der runden Innenkontur des Halteabschnitts folgen. D.h. die abgerundeten Ecken entsprechen den ersten Segmenten und die dazwischen angeordneten geraden Seiten des Polygons entsprechen den zweiten Segmenten, wie oben beschrieben.

Ebenfalls denkbar ist jedoch auch, dass die Innenkontur der Durchgangsöffnung im Bereich des vorderseitigen Endes des Basiselementes (insbesondere im Halteabschnitt) um den Umfang verteilt und einander abwechselnde erste und zweite Segmente aufweist, wobei die ersten Segmente der Aussenkontur der Abdeckung folgen und die zweiten Segmente von dieser radial nach aussen abweichen. Beispielsweise kann die Aussenkontur der Abdeckung rund sein und die Innenkontur in dem Halteabschnitt hiervon abweichen. Z.B. kann die Innenkontur in dem Halteabschnitt eine runde Grundkontur und mit mindestens einer sich von der Grundkontur in radialer Richtung nach aussen erstreckenden Vertiefung aufweisen. Die Vertiefungen bilden hierbei die zweiten Segmente aus, die von der Aussenkontur der Abdeckung radial nach aussen abweichen. Die zwischen den Vertiefungen angeordneten runden Abschnitte der Grundkontur bilden die ersten Segmente aus, welche der Aussenkontur der Abdeckung folgen. Die Vertiefung der Kontur dient also zur Ausbildung eines jeweiligen Belüftungskanals. Z.B. kann von dem vorderseitigen Ende mindestens eine in axialer Richtung verlaufende Nut in der Durchgangsöffnung und im Halteabschnitt abgeordnet sein. Die (dreidimensionale) Nut bildet (im Schnitt) die (zwei dimensionale) Vertiefung der Innenkontur aus. Mit Vorteil sind jedoch mehrere um den Umfang der Durchgangsöffnung angeordnete, sich in axiale Richtung erstreckende Nuten vorhanden. In einer jeder Nut verläuft also zumindest bereichsweise je ein Belüftungskanal. Mit Vorteil erstrecket sich die mindestens eine Nut oder die Nuten in axialer Richtung über den Halteabschnitt, insbesondere in den Dichtabschnitt.

Je nach Ausgestaltung kann der mindestens eine Belüftungskanal am vorderseitigen Ende um die Abdeckung umlaufend sein. Hierzu kann die Durchgangsöffnung am vorderseitigen Ende einen Belüftungsabschnitt aufweisen. Die Abdeckung erstreckt sich in diesem Fall in axialer Richtung über den Halteabschnitt und zumindest bereichsweise über den Belüftungsabschnitt. In dem Belüftungsabschnitt ist die Innenkontur der Durchgangsöffnung um den Umfang herum zur Kontur der Abdeckung beabstandet. D.h. es wird ein umlaufender Spalt ausgebildet. Dieser kann Teil des Belüftungskanals sein. In dem umlaufenden Spalt kann sich das durch das Druckausgleichselement durchgeführte Gas derart verteilen, dass es um die Abdeckung umlaufend in die Umgebung austritt. Wenn mehrere Belüftungskanäle vorhanden sind, können diese je in den umlaufenden Spalt verlaufen.

Das Dichtelement dient zum Dichten der Membran gegen das Basiselement, insbesondere in axialer Richtung und/oder radialer Richtung. Je nach Anwendung kann das Dichtelement ein elastisches Material umfassen. Mit Vorteil ist das Dichtelement in die axiale Richtung und in die radiale Richtung elastisch deformierbar. Je nach Anwendung kann das Dichtelement ringförmig oder scheibenförmig sein. Beispielsweise kann das Dichtelement eine Basis aufweisen. Die Basis kann beispielsweise ringförmig sein. Unter ringförmig wird verstanden, dass das Dichtelement einen umlaufenden eckigen und/oder runden Querschnitt haben kann. Aus der axialen Richtung betrachtet kann das ringförmige Dichtelement oder die ringförmige Basis ebenfalls eckig als auch rund sein. Weiter kann die Basis beispielsweise scheibenförmig sein. Unter scheibenförmig wird verstanden, dass das Dichtelement einen umlaufenden eckigen und/oder runden Querschnitt haben kann. Aus der axialen Richtung betrachtet kann das scheibenförmige Dichtelement resp. die scheibenförmige Basis ebenfalls eckig als auch rund sein. Das Dichtelement, insbesondere die ringförmige oder scheibenförmige Basis, kann im montierten Zustand an der Membran anliegen und die Membran (in axiale Richtung) an das Basiselement, insbesondere den Absatz des Basiselementes, andrücken. Das Dichtelement, insbesondere die ringförmige oder scheibenförmige Basis, kann also eine axiale Dichtfläche zum Abdichten gegen die Membran in axialer Richtung aufweisen. Alternativ oder ergänzend kann das Dichtelement, insbesondere die ringförmige oder scheibenförmige Basis, eine radiale Dichtfläche zum Abdichten gegen eine Innenfläche des röhrenförmigen Basiselementes in radialer Richtung aufweisen. Dadurch wird eine erhöhte Dichtigkeit des Druckausgleichselementes erzeugt. Mit Vorteil ist das Dichtelement derart ausgelegt, dass eine axiale Kompression des Dichtelementes eine radiale Expansion des Dichtelementes bewirkt. D.h. beim Andrücken des Dichtelementes in axialer Richtung an die axiale Dichtfläche, wird das Dichtelement axial komprimiert und radial expandiert, sodass das Dichtelement simultan in axialer Richtung an die axiale Dichtfläche und radialer Richtung an die radiale Dichtfläche angedrückt wird. Je nach Anwendung, jedoch insbesondere, wenn das Dichtelement ein scheibenförmiges Dichtelement ist, kann das Material des Dichtelementes gasdurchlässig sein. Z.B. kann das Material porös sein. Als Materialien bieten sich beispielsweise PE, PFT oder PTFE an.

Je nach Anwendung, jedoch insbesondere, wenn das Dichtelement eine ringförmige Basis umfasst, kann der direkte Flüssigkeitskontakt auf die Membran indirekt durch eine Umlenkung des Flüssigkeitsstrahls verhindert werden. Je nach Anwendung, jedoch insbesondere, wenn das Dichtelement eine scheibenförmige Basis umfasst, kann der Flüssigkeitskontakt auf die Membran indirekt durch eine Umlenkung des Flüssigkeitsstrahls und/oder durch den direkten zusätzlichen Schutz der Membran durch das scheibenförmige Dichtelement verhindert werden.

Je nach Anwendung kann das Dichtelement ebenfalls in der Durchgangsöffnung, insbesondere in dem Dichtabschnitt, form- und oder kraftschlüssig gehalten sein. Dies gilt vor allem für den undeformierten Zustand des Dichtelementes. Dies bietet sich insbesondere an, wenn das Dichtelement infolge der Materialeigenschaft radial nicht oder nur wenig deformierbar ist. Durch den Form- und/oder Kraftschluss wird somit die Dichtung in radiale Richtung ohne eine Deformation des Dichtelementes ermöglicht.

Je nach Anwendung kann das Dichtelement mehrere um den Umfang der ringförmigen Basis verteilt angeordnete Abstandselemente aufweisen, die in axialer Richtung von der ringförmigen Basis abragen und sich je von einem proximalen Ende zu einem distalen Ende erstrecken. Am proximalen Ende ist das jeweilige Abstandselement mit Vorteil an der ringförmigen Basis angeformt. Das distale Ende ist je ein freies Ende. Im montierten Zustand liegt die Abdeckung auf den jeweiligen distalen Enden der Abstandselemente auf. Die distalen Enden weisen hierzu mit Vorteil je eine abgeflachte Anlagefläche zur Anlage an der Abdeckung auf. Für eine gute Dichtwirkung kann es vorteilhaft sein, dass ein Abstand in axialer Richtung zwischen dem Anschlag für die Abdeckung und dem Absatz für die Membran kleiner ist als eine Erstreckung in axialer Richtung des Dichtelementes in einem undeformierten Zustand und der Membran. Auf die Weise kann eine ausreichende Kompression des Dichtelementes erzeigt werden. Die Abstandselemente dienen also u.a. zur Krafteinleitung auf die ringförmige Basis zur Deformation desselben.

Zwischen den jeweiligen benachbarten Abstandselementen, der Abdeckung und der ringförmigen Basis kann (im montierten Zustand) zudem ein Zuführkanal ausgebildet sein. Der Zuführkanal dient dazu durch die Membran gefiltertes Gas dem Belüftungskanal oder -kanälen zuzuführen. Mit Vorteil sind mehrere um den Umfang des Dichtelementes verteilt angeordnete Zuführkanäle vorhanden. Die Anzahl der (mehreren) Zuführkanäle unterscheidet sich mit Vorzug von der Anzahl der (mehreren) Belüftungskanäle. Dies dient dazu, dass auch bei einer relativen Verschiebung der Abdeckung und/oder des Basiselementes zum Dichtelement ein Druckausgleich, respektive ein Austreten eines Gases aus der Durchgangsöffnung gewährleistet ist.

Die Membran selbst kann aus verschiedenen Materialien bestehen. Die Materialien weisen mit Vorteil eine hohe Beständigkeit gegen unterschiedliche Chemikalien, hohe Temperaturen und ultravioletter Strahlung auf. Zusätzlich kann die Membran auch lipophob sein. Mit Vorteil besteht die Membran aus Materialien wie beispielsweise aus PFOA- und/oder PFOS-freien ePTFE-Membranmaterialien. Diese Membranmaterialien sind nicht nur insbesondere hydrophob, sondern auch oleophob. Des Weiteren kann die Membran je nach Anwendungsgebiet des Druckausgleichselements mindestens ein zusätzliches Additiv enthalten. Das mindestens eine Additiv kann beispielsweise direkt in der Matrix der mit Vorteil aus ePTFE-Materialien bestehenden Membran enthalten sein. Alternativ kann das mindestens eine Additiv auf die Membran aufgetragen sein. Das mindestens eine Additiv kann beispielsweise ein Adsorptions- und/oder ein Absorptionsmittel sein. Das mindestens eine Additiv kann beispielsweise auch ein antimikrobielles Lösungsmittel sein. Je nach Anwendungsgebiet ist eine Kombination der Additive auch denkbar. Die Membran kann dabei eine faserartige (respektive fibrilläre) Struktur aufweisen. Des Weiteren kann die Membran an einer Seite eine Klebefläche für eine vereinfachte Anbringung der Membran aufweisen. D.h. die Membran kann selbstklebend an das Basiselement angebracht werden.

In einer weiteren Ausführungsformen wäre es denkbar, ein röhrenförmiges Basiselement, eine Abdeckung sowie ein Dichtelement ohne eine Membran bereitzustellen. Diese Ausführungsformen dienen dazu ein Druckausgleichselement bereitzustellen, welche einen grösseren Volumenausgleich zwischen einem Gehäuse- oder Behälterinnenraum und Umgebung ermöglichen. Der Volumenausgleich kann durch das nicht Vorhandensein der Membran weniger genau geregelt werden. D.h. das Druckausgleichselement ist grossporiger und lässt einen grösseren Volumenstrom passieren. Das Basiselement, die Abdeckung sowie das Dichtelement können wie oben und weiter unten beschrieben ausgebildet sein. Mit Vorteil ist das Dichtelement, respektive das Basiselement, scheibenförmig ausgebildet.

### KURZBESCHREIBUNG DER FIGUREN

Anhand der in den nachfolgenden Figuren gaezeigten Ausführungsbeispiele und der dazugehörigen Beschreibung werden Aspekte der Erfindung näher erläutert. Es zeigen:
- Fig. 1: Eine erste Ausführungsform eines Druckausgleichselements gemäss der Erfindung in einer Draufsicht;
- Fig. 2: Schnittansicht durch die Schnittebene A-A des Druckausgleichselements nach Figur 1;
- Fig. 3: Explosionsansicht des Druckausgleichselements nach Figur 1 in einer perspektivischen Ansicht;
- Fig. 4: Eine zweite Ausführungsform eines Druckausgleichselements gemäss der Erfindung in einer Draufsicht;
- Fig. 5: Schnittansicht durch die Schnittebene B-B des Druckausgleichselements nach Figur 4;
- Fig. 6: Explosionsansicht des Druckausgleichselements nach Figur 4 in einer perspektivischen Ansicht;
- Fig. 7: Eine dritte Ausführungsform eines Druckausgleichselements gemäss der Erfindung in einer perspektivischen Explosionsansicht.

### BESCHREIBUNG DER AUSFÜHRUNGSFORMEN

Im Folgenden wird im Detail auf bestimmte Ausführungsformen der Erfindung Bezug genommen, von denen Beispiele in den beigefügten Figuren dargestellt sind, in denen einige, aber nicht alle Merkmale gezeigt werden. In der Tat können die hier offengelegten Ausführungsformen in vielen verschiedenen Formen verkörpert werden und sollten nicht so ausgelegt werden, dass sie auf die hier dargelegten Ausführungsformen beschränkt sind; vielmehr werden diese Ausführungsformen bereitgestellt, damit diese Offenlegung den geltenden rechtlichen Anforderungen genügt. Wann immer möglich, werden gleiche Referenznummern verwendet, um auf die gleichen Komponenten oder Teile zu verweisen. Vielmehr sind die in der Beschreibung verwendeten Wörter eher beschreibend als einschränkend, und es versteht sich, dass verschiedene Änderungen vorgenommen werden können, ohne vom Umfang der Offenlegung abzuweichen.

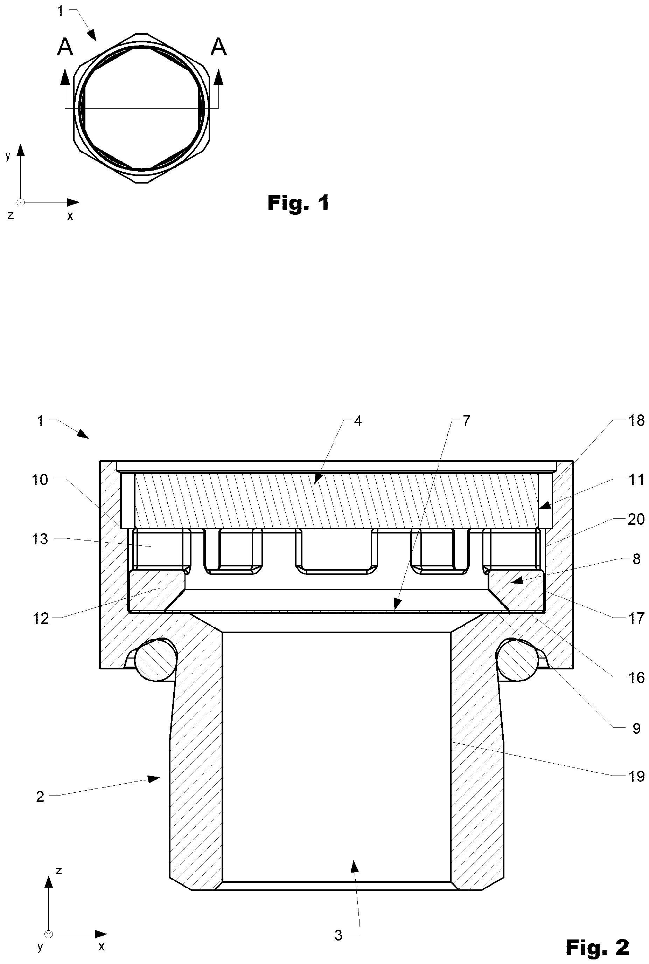

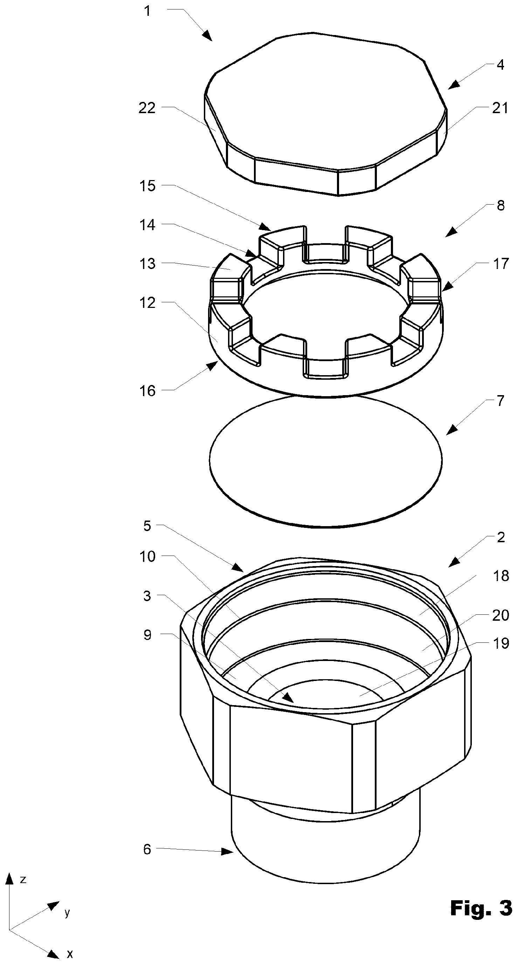

Figur 1 - Figur 3 zeigen eine erste Ausführungsform eines Druckausgleichselements 1 gemäss der Erfindung. **Figur 1** und **Figur 2** zeigen das Druckausgleichselement 1 in zusammengesetztem Zustand und **Figur 3** zeigt das Druckausgleichselement 1 in einer Explosionsansicht.

Das gezeigte Druckausgleichselement 1 umfasst ein Basiselement 2, eine Abdeckung 4, eine Membran 7 sowie ein Dichtelement 8. Das Basiselement 2 erstreckt sich in axiale Richtung von einem rückseitigen Ende 6 zu einem gegenüberliegenden vorderseitigen Ende 5 und umgibt eine Durchgangsöffnung 3. Die Durchgangsöffnung 3 weist dabei am rückseitigen Ende 6 einen kleineren Durchmesser auf als an dem vorderseitigen Ende 5. Die Durchgangsöffnung 3 weist einen Halteabschnitt 18 zur Befestigung der Abdeckung 4, einen Dichtabschnitt 20 zur Aufnahme des Dichtelementes 8 und der Membran 7 und einen rückseitigen Abschnitt 19 auf. Es ist denkbar, dass der rückseitige Abschnitt 19 zumindest teilweise in axialer Richtung von einem Aussengewinde am Basiselement 2 umgeben ist (nicht dargestellt). Der Halteabschnitt 18 weist in dieser Ausführungsform eine runde Innenkontur der Durchgangsöffnung 3 auf. Die Durchgangsöffnung 3 weist zwischen dem Halteabschnitt 18 und dem Dichtungsabschnitt 20 einen Anschlag 10 auf. Der Anschlag 10 dient zur Anlage der Abdeckung 4 und ist in dieser Ausführungsform in radialer Richtung umlaufend ausgebildet. Einen in radialer Richtung nur partiell umlaufend angeordneten Anschlag 10 ist ebenfalls denkbar. Des Weiteren weist die Durchgangsöffnung 3 einen umlaufenden Absatz 9 auf. Der Absatz 9 dient zur Anlage der Membran 7 in die axiale Richtung und ist zwischen dem Dichtabschnitt 20 und dem rückseitigen Abschnitt 19 angeordnet. Der Absatz 9 ist in dieser Ausführungsform des Druckausgleichselements 1 senkrecht zur axialen Richtung orientiert, wie auch in **Figur 2** erkennbar. Die Membran 7 ist flüssigkeitsundurchlässig. Weiter besteht die Membran mit Vorteil zusätzlich aus einem lipophoben Material wie beispielsweise aus PFOA- und PFOS-freien ePTFE-Materialien. Des Weiteren weist die Membran 7 für die vereinfachte Anbringung an den Absatz 9 mit Vorteil eine selbstlebende Klebefläche auf.

Wie insbesondere in **Figur 3** gut erkennbar, umfasst das Dichtelement 8 eine ringförmige Basis 12 mit einer axialen Dichtfläche 16 und einer radialen Dichtfläche 17. Das Dichtelement 8 weist weiter mehrere, um den Umfang der ringförmigen Basis 12 verteilt angeordnete Abstandselemente 13 auf. Die Abstandselemente 13 ragen von der Basis 12 ab und sind auf dieser rotationssymmetrisch angeordnet. Die Abstandselemente 13 erstrecken sich dabei von je einem proximalen Ende 14 zu einem distalen Ende 15. Die Abdeckung 4 weist die Form eines Polygons mit geraden Segmenten und abgerundeten Ecken, bzw. Segmenten. Hierbei entsprechen abgerundeten Segmente den ersten Segmenten 21, und die geraden Segmente den zweiten Segmenten 22, wie oben beschrieben. Die ersten Segmente 21 folgen der Innenkontur des Basiselementes 2 im Halteabschnitt 18 der Durchgangsöffnung 3. Die zweiten Segmente 22 weichen hingegen in radialer Richtung von der Innenkontur des Basiselementes 2 im Halteabschnitt 18 der Durchgangsöffnung 3 nach innen ab. Die ersten Segmente 21 und die zweiten Segmente 22 sind um den gesamten Umfang der Abdeckung 4 alternierend angeordnet.

**Figur 2** zeigt eine Schnittansicht durch die in der **Figur 1** gezeigten Schnittebene A-A des Druckausgleichselements 1. Die Membran 7 liegt ersichtlich an dem in der Durchgangsöffnung 3 angebrachten senkrecht zur axialen Richtung orientierte Absatz 9 auf. Das Dichtelement 8 umfasst ein elastisches Material und dessen Basis liegt an der Membran 7 sowie an der Innenkontur des röhrenförmigen Basiselements 2 an. Das Dichtelement 8 ist in axialer und radialer Richtung deformierbar. Da der Abstand in axialer Richtung zwischen dem Anschlag für die Abdeckung 4 und dem Absatz für die Membran 7 kleiner ist als die Erstreckung des Dichtelements 8 in axialer Richtung, liegt das Dichtelement 8 in einem deformierten Zustand vor. Dadurch wird die Basis des Dichtelements 8 in axialer Richtung mit der axialen Dichtfläche 16 gegen die Membran 7 gedrückt und dichtet diese ab. Durch die Kompression in axialer Richtung wird das Dichtelement 8 radial expandiert und gegen die radiale Dichtfläche 17 an die Innenkontur des röhrenförmigen Basiselements 2 gedrückt. Die Abdeckung 4 wird in dieser Ausführung mittels Form- und Kraftschluss versenkt im Halteabschnitt 18 der Durchgangsöffnung 3 gehalten. Die ersten Segmente 21 der Abdeckung 4 bilden dabei jeweils mit der Innenkontur des Basiselementes 2 im Halteabschnitt der Durchgangsöffnung 3 den Form- und Kraftschluss aus. Da die zweiten Segmente 22 von der Innenkontur des Basiselementes 2 im Halteabschnitt 18 der Durchgangsöffnung 3 abweichen, bildet sich jeweils ein Spalt zwischen der Abdeckung 4 und dem Basiselement 2 aus. Diese Spalte bilden die Belüftungskanäle 11 aus. Die Belüftungskanäle 11 sind dabei rotationssymmetrisch angeordnet. Durch die Anordnung von Dichtelement 8 und Abdeckung 4 wird ein auf das Druckausgleichselement 1 auftreffender Flüssigkeitsstrahl, wie beispielsweise ein Wasserstrahl, umgelenkt und ein direkter Kontakt auf die Membran 7 wird verhindert.

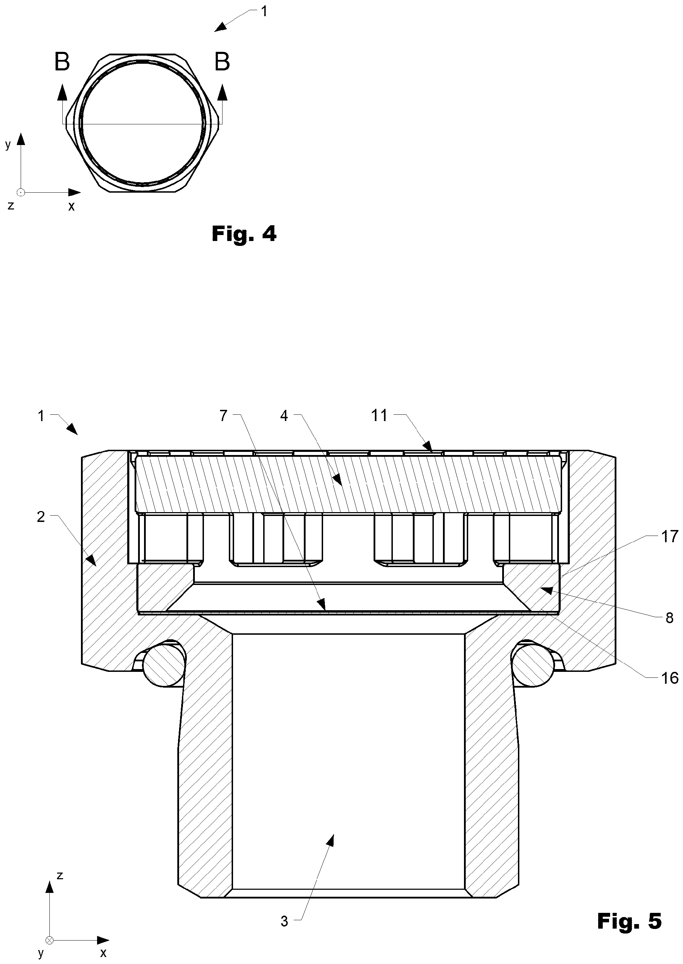

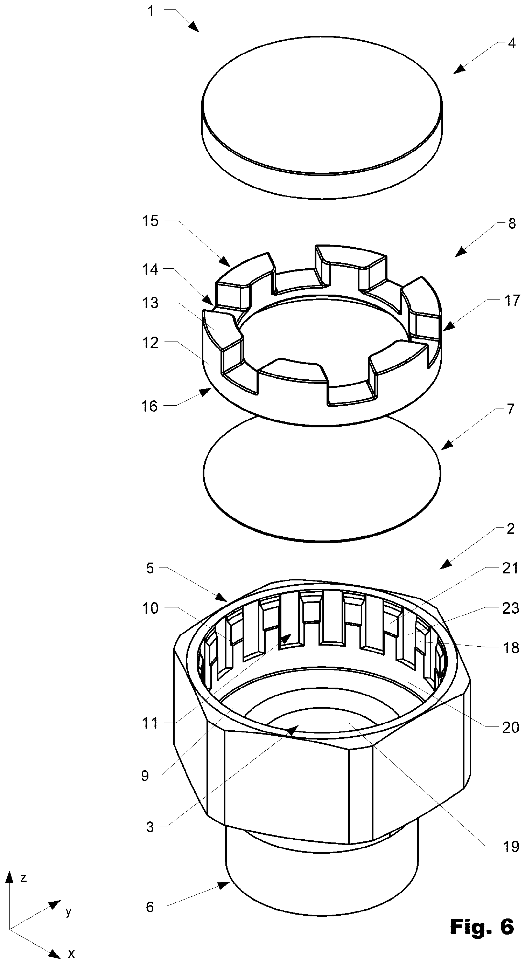

Figur 4 - Figur 6 zeigen eine zweite Ausführungsform eines Druckausgleichselements 1 gemäss der Erfindung. **Figur 4** zeigt eine Draufsicht eines Ausführungsbeispiels einer zweiten Ausführungsform eines Druckausgleichselements 1 in zusammengesetztem Zustand und **Figur 6** zeigt das in **Figur 4** gezeigte Druckausgleichselement 1 in einer Explosionsansicht und **Figur 5** eine entsprechende Schnittansicht.

Die zweite Ausführungsform unterscheidet sich zur ersten Ausführungsform insbesondere darin, dass die Belüftungskanäle 11 unterschiedlich ausgebildet sind. Das gezeigte Druckausgleichselement 1 umfasst also ebenfalls ein Basiselement 2, eine Abdeckung 4, eine Membran 7 sowie ein Dichtelement 8. Das Basiselement 2 erstreckt sich in axiale Richtung von einem rückseitigen Ende 6 zu einem gegenüberliegenden vorderseitigen Ende 5 und umgibt eine Durchgangsöffnung 3 für den Durchgang eines Gases.

Wie in **Figur 6** erkennbar, weist die Durchgangsöffnung 3 ebenfalls einen Halteabschnitt 18 zur Befestigung der Abdeckung 4, einen Dichtabschnitt 20 zur Aufnahme des Dichtelementes 8 und der Membran 7 und einen rückseitigen Abschnitt 19 auf. Im Gegensatz zu ersten Ausführungsform weist die Innenkontur des Basiselementes 2 jedoch im Halteabschnitt 18 der Durchgangsöffnung 3 in dieser Ausführung eine runde Grundkontur und mehrere, sich von der Grundkontur in radialer Richtung nach aussen erstreckende rotationssymmetrische Vertiefungen auf. D.h. in dieser Ausführung sind an der Innenseite am vorderseitigen Endes 5 des Basiselementes 2 mehrere Nuten 23 angeordnet, welche bereichsweise die Wandung der Belüftungskanäle 11 ausbilden. Des Weiteren weist die Durchgangsöffnung 3 zwischen dem Halteabschnitt 18 und dem Dichtungsabschnitt 20 einen Anschlag 10 auf. Der Anschlag 10 dient zur Anlage der Abdeckung 4 und ist in dieser Ausführungsform in radialer Richtung nur partiell umlaufend angeordnet. Des Weiteren weist die Durchgangsöffnung 3 einen umlaufenden Absatz 9 auf. Der Absatz 9 dient zur Anlage der Membran 7 in die axiale Richtung und ist zwischen dem Dichtabschnitt 20 und dem rückseitigen Abschnitt 19 angeordnet. Der Absatz 9 ist in dieser Ausführungsform des Druckausgleichselements 1 senkrecht zur axialen Richtung orientiert.

Wie in **Figur 6** erkennbar, weist die Abdeckung 4 eine runde Aussenkontur auf. Die runde Aussenkontur der Abdeckung 4 folgt dabei der runden Grundkontur der Innenkontur des Basiselements 2 im Halteabschnitt 18 der Durchgangsöffnung 3. Die Membran 7 und das Dichtelement 8 können gleich ausgestaltet sein, wie in der ersten Ausführungsform, oder weiter oben beschrieben. Das Dichtelement 8 ist gleich aufgebaut wie in der ersten Ausführungsform.

Wie in **Figur 5** erkennbar, liegt die Membran 7 an dem in der Durchgangsöffnung 3 angebrachten senkrecht zur axialen Richtung orientierte Absatz 9 auf. Auch hier ist der Abstand in axialer Richtung zwischen dem Anschlag für die Abdeckung 4 und dem Absatz für die Membran 7 kleiner ist als die Erstreckung des Dichtelements 8 in axialer Richtung. D.h. das gezeigte Dichtelement 8 liegt in einem deformierten Zustand vor. Dadurch wird die Basis des Dichtelements 8 in axialer Richtung mit der axialen Dichtfläche 16 gegen die Membran 7 gedrückt und dichtet diese ab. Zudem wird die radiale Dichtfläche 17 an die Innenkontur des röhrenförmigen Basiselements 2 gedrückt und bildet somit die Abdichtung in radiale Richtung. Die Abdeckung 4 ist in dieser Ausführung versenkt in der Durchgangsöffnung 3 angeordnet. Dabei bildet die runde Aussenkontur der Abdeckung 4 mit der runden Grundkontur der Innenkontur des Basiselementes 2 (in ersten Segmenten 21) einen Form- und Kraftschluss. Zwischen der runden Aussenkontur der Abdeckung 4 und den von der Grundkontur in radialer Richtung nach aussen erstreckende rotationssymmetrische Vertiefungen (zweite Segmente) bildet sich hingegen jeweils einen Spalt. Dadurch erstrecken sich die rotationssymmetrischen Belüftungskanäle 11 in axialer Richtung über die Abdeckung 4 hinaus. Durch die Anordnung von Dichtelement 8 und Abdeckung 4 wird ein auf das Druckausgleichselement 1 auftreffender Flüssigkeitsstrahl, wie beispielsweise ein Wasserstrahl, umgelenkt und ein direkter Kontakt auf die Membran 7 wird verhindert.

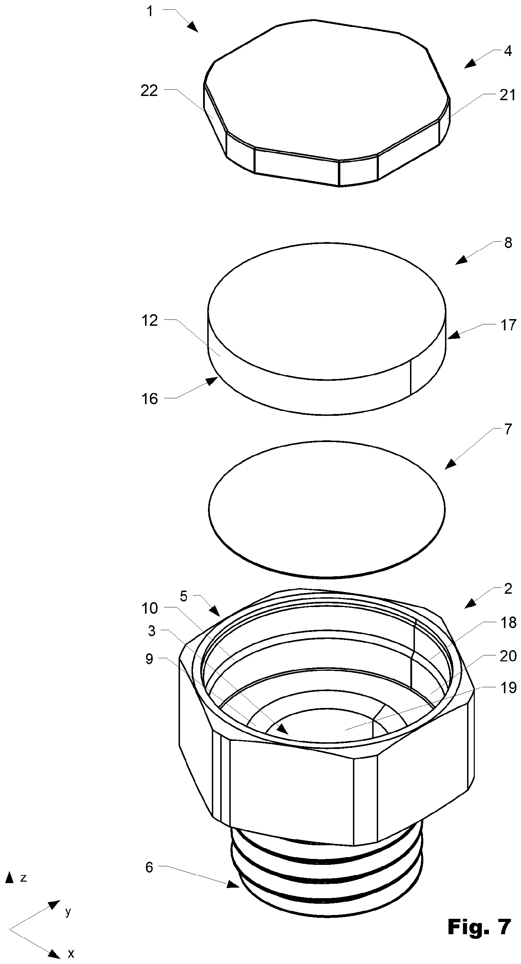

**Figur 7** zeigt eine dritte Ausführungsform eines Druckausgleichselements 1 gemäss der Erfindung in einer Explosionsansicht. Das in der **Figur 7** gezeigte Druckausgleichselement 1 unterscheidet sich von der in der **Figur 3** gezeigten Ausführungsform des Druckausgleichselements 1 in der Form des Dichtelements 8. Des Weiteren ist in dieser Ausführungsform erkennbar, dass der rückseitige Abschnitt 19 zumindest teilweise in axialer Richtung von einem Aussengewinde am Basiselement 2 umgeben ist.

Wie in **Figur 7** erkennbar, ist das Dichtelement 8 scheibenförmig ausgebildet. Weiter umfasst das Dichtelement 8 eine scheibenförmige Basis 12 mit einer axialen Dichtfläche 16 und einer radialen Dichtfläche 17. Das Dichtelement ist in montiertem Zustand in der Durchgangsöffnung 3, insbesondere im Dichtabschnitt 20 form- und kraftschlüssig gehalten. Weiter ist das Dichtelement 8 gasdurchlässig. Das Dichtelement 8 kann aus einem axial komprimierbaren sowie radial expandierbaren Material (wie beispielsweise PE, PFT oder PTFE) bestehen. Der direkte Kontakt eines Flüssigkeitsstrahls, wie beispielsweise eines Wasserstrahls, auf die Membran 7 wird durch den zusätzlichen Schutz des Dichtelements 8 einerseits, sowie durch Umlenkung mittels Anordnung von Abdeckung 4 und Dichtelement 8 verhindert.

### LISTE DER BEZUGSZEICHEN

| | | | |
|---|---|---|---|
| 1 | Druckausgleichselement | 14 | Proximales Ende |
| 2 | Basiselement | 15 | Distales Ende |
| 3 | Durchgangsöffnung | 16 | Axiale Dichtfläche |
| 4 | Abdeckung | 17 | Radiale Dichtfläche |
| 5 | Vorderseitiges Ende | 18 | Halteabschnitt |
| 6 | Rückseitiges Ende | 19 | Rückseitiger Abschnitt |
| 7 | Membran | 20 | Dichtabschnitt |
| 8 | Dichtelement | 21 | Erstes Segment |
| 9 | Absatz | 22 | Zweites Segment |
| 10 | Anschlag | 23 | Nut |
| 11 | Belüftungskanal | | |
| 12 | Basis | | |
| 13 | Abstandselement | | |

## Patentansprüche

1. Druckausgleichselement (1) zur Bereitstellung eines Druckausgleichs, das Druckausgleichselement (1) umfassend
a. ein sich in eine axiale Richtung von einem vorderseitigen Ende (5) zu einem rückseitigen Ende (6) erstreckendes röhrenförmiges Basiselement (2), mit einer von dem röhrenförmigen Basiselement (2) ausgebildeten Durchgangsöffnung (3),
b. eine Abdeckung (4), welche an dem vorderseitigen Ende (5) des Basiselementes (2) in der Durchgangsöffnung (3) angeordnet ist;
c. eine in der Durchgangsöffnung (3) angeordnete Membran (7); sowie
d. ein in axialer Richtung zwischen der Membran (7) und der Abdeckung (4) angeordnetes Dichtelement (8), wobei
e. die Membran (7) und das Dichtelement (8) in axialer Richtung zumindest bereichsweise zwischen dem Basiselement (2) und der Abdeckung (4) von der Abdeckung (4) gehalten werden.

2. Druckausgleichselement (1) gemäss einem der vorangehenden Patentansprüche, **dadurch gekennzeichnet, dass** das Druckausgleichselement (1) mindestens ein Belüftungskanal (11) umfasst, welcher sich zwischen der Abdeckung (4) und dem Basiselement (2) und/oder durch die Abdeckung (4) erstreckt.

3. Druckausgleichselement (1) gemäss Patentanspruch 2, **dadurch gekennzeichnet, dass** eine Innenkontur der Durchgangsöffnung (3) in einem Halteabschnitt (18) der Durchgangsöffnung (3) derart von einer Aussenkontur der Abdeckung (4) abweicht, sodass der mindestens eine Belüftungskanal (11) dazwischen ausgebildet wird.

4. Druckausgleichselement (1) gemäss Patentanspruch 3, **dadurch gekennzeichnet, dass** die Aussenkontur der Abdeckung (4) um den Umfang verteilt und einander abwechselnde erste und zweite Segmente (21, 22) aufweist, wobei die ersten Segmente (21) der Innenkontur der Durchgangsöffnung (3) in dem Halteabschnitt (18) folgen und die zweiten Segmente (22) von dieser radial nach innen abweichen.

5. Druckausgleichselement (1) gemäss Patentanspruch 3, **dadurch gekennzeichnet, dass** die Innenkontur der Durchgangsöffnung (3) in dem Halteabschnitt (18) um den Umfang verteilt und einander abwechselnde erste und zweite Segmente (21, 22) aufweist, wobei die ersten Segmente (21) der Aussenkontur der Abdeckung (4) folgen und die zweiten Segmente (22) von dieser radial nach aussen abweichen.

6. Druckausgleichselement (1) gemäss einen der Patentansprüche 2 - 5, **dadurch gekennzeichnet, dass** mehrere um den Umfang der Abdeckung (4) herum angeordnete Belüftungskanäle (11) vorhanden sind.

7. Druckausgleichselement (1) gemäss einem der vorangehenden Patentansprüche, **dadurch gekennzeichnet, dass** das Dichtelement (8) eine axiale Dichtfläche (16) zum Abdichten gegen die Membran (7) in axialer Richtung und/oder eine radiale Dichtfläche (17) zum Abdichten gegen eine Innenfläche des röhrenförmigen Basiselementes (2) in radialer Richtung aufweist.

8. Druckausgleichselement (1) gemäss einem der vorangehenden Patentansprüche, **dadurch gekennzeichnet, dass** das Dichtelement (8) axial und/oder radial deformierbar ist.

9. Druckausgleichselement (1) gemäss einem der vorangehenden Patentansprüche, **dadurch gekennzeichnet, dass** das Dichtelement (8) eine ringförmige oder scheibenförmige Basis (12) umfasst.

10. Druckausgleichselement (1) gemäss Patentanspruch 9, **dadurch gekennzeichnet, dass** das Dichtelement (8) mehrere um den Umfang der ringförmigen Basis verteilt angeordnete Abstandselemente (13) aufweist, die in axialer Richtung von der ringförmigen Basis (12) abragen und sich je von einem proximalen Ende (14) zu einem distalen Ende (15) erstrecken.

11. Druckausgleichselement (1) gemäss Patentanspruch 10, **dadurch gekennzeichnet, dass** die Abdeckung (4) im montierten Zustand auf den jeweiligen distalen Enden der Abstandselemente (13) aufliegt.

12. Druckausgleichselement (1) gemäss einem der vorangehenden Patentansprüche, **dadurch gekennzeichnet, dass** die Abdeckung (4) in der Durchgangsöffnung (3) versenkt angeordnet ist.

13. Druckausgleichselement (1) gemäss einem der vorangehenden Patentansprüche, **dadurch gekennzeichnet, dass** die Abdeckung (4) formschlüssig und/oder kraftschlüssig in einem/dem Halteabschnitt (18) der Durchgangsöffnung (3) gehalten wird.

14. Druckausgleichselement (1) gemäss einem der vorangehenden Patentansprüche, **dadurch gekennzeichnet, dass** die Durchgangsöffnung (3) einen Anschlag (10) in axialer Richtung für die Abdeckung (4) aufweist und/oder zwischen dem vorderseitigen und dem rückseitigen Ende (5 ,6) einen Absatz (9) zur Anlage der Membran (7) in die axiale Richtung aufweist.

15. Druckausgleichselement (1) gemäss Patentanspruch 14, **dadurch gekennzeichnet, dass** ein Abstand in axialer Richtung zwischen dem Anschlag (10) für die Abdeckung und dem Absatz (9) für die Membran (7) kleiner ist als eine Erstreckung in axialer Richtung des Dichtelementes (8) und in einem undeformierten Zustand.
